(19) Europäisches Patentamt
European Patent Office
Office européen des brevets

(11) **EP 4 582 821 B1**

(12) **EUROPEAN PATENT SPECIFICATION**

(45) Date of publication and mention of the grant of the patent:
**22.04.2026   Bulletin 2026/17**

(21) Application number: **24213189.4**

(22) Date of filing: **15.11.2024**

(51) International Patent Classification (IPC):
***G01R 31/367*** (2019.01)    ***G01R 31/389*** (2019.01)

(52) Cooperative Patent Classification (CPC):
**G01R 31/389; G01R 31/367**

(54) **METHOD AND APPARATUS FOR MEASURING INTERNAL RESISTANCE OF BATTERY**

VERFAHREN UND VORRICHTUNG ZUR MESSUNG DES INNENWIDERSTANDES EINER BATTERIE

PROCÉDÉ ET APPAREIL DE MESURE DE LA RÉSISTANCE INTERNE D'UNE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **04.01.2024   KR 20240001516**

(43) Date of publication of application:
**09.07.2025   Bulletin 2025/28**

(73) Proprietor: **SAMSUNG SDI CO., LTD.**
**Yongin-si, Gyeonggi-do 17084 (KR)**

(72) Inventors:
• **Lee, Juhyung**
**17084 Yongin-si, Gyeonggi-do (KR)**

• **Lee, Jiyoung**
**17084 Yongin-si, Gyeonggi-do (KR)**
• **Choi, Yeji**
**17084 Yongin-si, Gyeonggi-do (KR)**
• **Yun, Wanhee**
**17084 Yongin-si, Gyeonggi-do (KR)**

(74) Representative: **Gulde & Partner**
**Patent- und Rechtsanwaltskanzlei mbB**
**Berliner Freiheit 2**
**10785 Berlin (DE)**

(56) References cited:
**JP-A- 2022 113 377     US-A1- 2022 260 642**

EP 4 582 821 B1

**Description**

**BACKGROUND**

**1. Field**

One or more embodiments relate to a method and apparatus for measuring an internal resistance of a battery.

**2. Description of the Related Art**

A secondary battery can be charged and discharged, unlike a primary battery, which cannot be recharged. Low-capacity secondary batteries are used in small portable electronic devices, such as smartphones, feature phones, laptop computers, digital cameras, and camcorders, and high-capacity secondary batteries are used as motor-driving power sources, power-storing batteries, etc., for hybrid vehicles, electric vehicles, etc. Such a secondary battery may include an electrode assembly including a cathode and an anode, a case accommodating the electrode assembly, an electrode terminal connected to the electrode assembly, etc.

To sort a product having a high possibility of an internal short-circuit defect in a battery at a mass production stage of batteries including secondary batteries, an internal resistance of the battery may be desired to be measured. At the mass production stage of the batteries, lines connected to a resistance-measuring apparatus have different lengths for each mass production line, resulting in a different inductance that is proportional to the lengths of the lines. Moreover, the inductance affects a capacitance and a resistance, thereby making it difficult to precisely measure an internal resistance of the battery. JP 2022 113377 A relates to a battery resistance calculation system for measuring the resistance of a secondary battery.

**SUMMARY**

One or more embodiments include a method and apparatus for effectively measuring an internal resistance of a battery. The present disclosure is not limited by the above, and other problems not mentioned may be clearly understood by those of ordinary skill in the art from the description of the present disclosure described below.

Additional aspects will be set forth in part in the description which follows and, in part, will be apparent from the description, or may be learned by practice of the presented embodiments of the present disclosure.

According to one or more embodiments, a method of measuring an internal resistance of a battery by using a battery-internal-resistance-measuring apparatus includes obtaining an initial internal resistance of the battery electrically connected to the battery-internal-resistance-measuring apparatus, fitting an equivalent circuit model including resistance elements, which correspond to an internal resistance component of the battery and a resistance component of the battery-internal-resistance-measuring apparatus, and an inductance element, which correspond to an inductance component of the battery-internal-resistance-measuring apparatus, based on the initial internal resistance, and deriving an internal resistance value of the battery based on a fitting result of the equivalent circuit model.

The equivalent circuit model may include one of the resistance elements corresponding to the resistance component in parallel (e.g., connected in parallel) to the inductance element corresponding to the inductance component.

The equivalent circuit model may include another one of the resistance elements corresponding to the internal resistance component in series (e.g., connected in series) to the inductance element. Hence, the equivalent circuit model may include a resistance element corresponding to the internal resistance component connected in series to the inductance element and/or a resistance element corresponding to the internal resistance component connected in parallel to the inductance element.

The deriving of the internal resistance value may include calculating the internal resistance value for a frequency range.

The frequency range may be about 100 Hz to about 10 kHz.

The method may be executed by a computer program stored on a recording medium by using a computing device.

According to one or more embodiments, a battery-internal-resistance-measuring apparatus, for measuring an internal resistance of a battery electrically connected thereto, includes a resistance component, an inductance component, a memory configured to store an equivalent circuit model including resistance elements corresponding to an internal resistance component of the battery and the resistance component, and an inductance element corresponding to the inductance component, and a processor configured to obtain an initial internal resistance value of the battery, configured to fit the equivalent circuit model based on the initial internal resistance value to generate a fitting result, and configured to derive an internal resistance value of the battery based on the fitting result.

The equivalent circuit model may include one of the resistance elements corresponding to the resistance component in parallel (e.g., connected in parallel) to the inductance element.

The equivalent circuit model may include another one of the resistance elements corresponding to the internal resistance component in series (e.g., connected in series) with the inductance element.

The processor may be further configured to calculate the internal resistance value for a frequency range.

The frequency range may be about 100 Hz to about 10 kHz. Alternatively, the frequency range may be about 50 Hz to about 20 kHz, or the frequency range may be about 500 Hz to about 5 kHz.

The term "battery-internal-resistance-measuring apparatus" may mean an apparatus capable or used for of measuring an internal resistance of a battery.

The frequency referred to may be the frequency of a change in polarity of an electric current, for example the frequency of an alternating electric current or an electric signal.

## BRIEF DESCRIPTION OF THE DRAWINGS

The above and other aspects of embodiments of the present disclosure will be more apparent from the following description taken in conjunction with the accompanying drawings.

The following drawings attached to this specification illustrate some embodiments of the present disclosure, and serve to further enable understanding of the present disclosure together with the detailed description of the present disclosure described later, so the present disclosure should not be construed as being limited to the matters shown in such drawings.

FIG. 1 schematically shows a battery-internal-resistance-measuring apparatus and a battery, according to embodiments of the present disclosure;

FIG. 2 schematically shows a battery-internal-resistance-measuring apparatus and a battery, according to embodiments of the present disclosure;

FIG. 3 is a view for describing an equivalent circuit model, according to embodiments of the present disclosure;

FIGS. 4 to 6 show graphs for results of measuring an internal resistance of a battery, according to embodiments of the present disclosure; and

FIG. 7 shows data of a result of measuring an internal resistance of a battery, according to embodiments of the present disclosure.

## DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

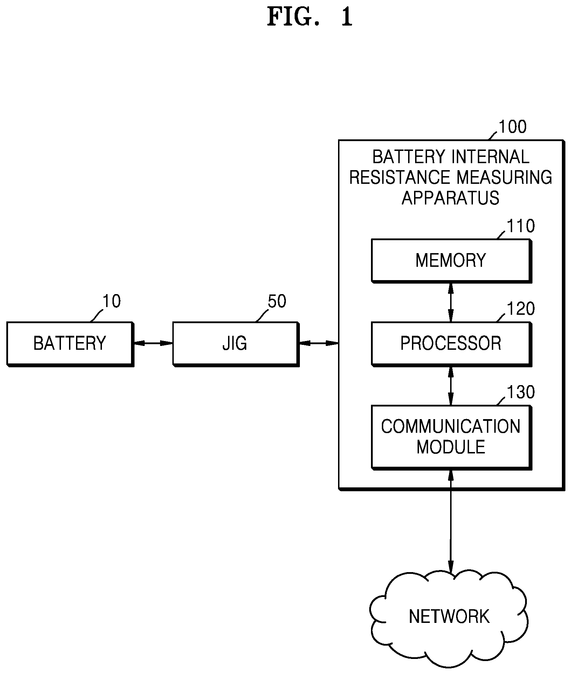

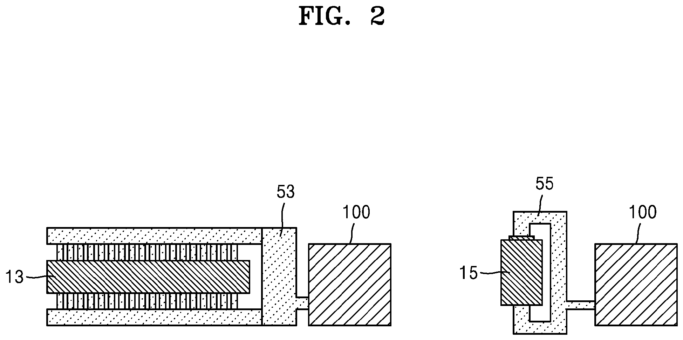

FIGS. 1 and 2 schematically show a battery-internal-resistance-measuring apparatus and a battery, according to embodiments of the present disclosure.

Referring to FIG. 1, a battery-internal-resistance-measuring apparatus 100 according to embodiments of the present disclosure may include a memory 110, a processor 120, and a communication module 130. The battery-internal-resistance-measuring apparatus 100 according to embodiments of the present disclosure may be electrically connected to a battery 10 to measure an internal resistance of the battery 10. For example, a jig 50 may be provided between the battery-internal-resistance-measuring apparatus 100 and the battery 10, and may connect the battery-internal-resistance-measuring apparatus 100 and the battery 10. The jig 50 may hold the battery 13 or a battery cell 15, respectively. It may be possible for the battery 13 or battery cell 15 to be clamped in the jig 50.

For example, referring to FIG. 2, the battery-internal-resistance-measuring apparatus 100 according to embodiments of the present disclosure may be electrically connected to the battery module 13 including a plurality of battery cells through a jig 53 to measure internal resistances of the plurality of battery cells. The battery-internal-resistance-measuring apparatus 100 according to embodiments of the present disclosure may be electrically connected to a single battery cell 15 through a jig 55 to measure an internal resistance of the single battery cell 15. For example, the battery module 13 may include at least one battery cell 15 that may be a chargeable secondary battery. For example, the battery cell 15 may include at least one selected from a group including a nickel-cadmium battery, a lead acid battery, a nickel metal hydride battery (NiMH), a lithium ion battery, a lithium polymer battery, etc.

The battery-internal-resistance-measuring apparatus 100 according to embodiments of the present disclosure may be an apparatus using an electrochemical impedance spectroscopy (EIS) measuring method. For example, the EIS measuring method may include a method of calculating an internal resistance value of a measurement target through a process of performing fitting on an equivalent circuit including an electric circuit element to accurately measure internal impedances (e.g., a resistance, a capacitance, and an impedance). A conventional EIS apparatus may be relatively costly, high-precision equipment, but the battery-internal-resistance-measuring apparatus 100 according to the present disclosure may be applied to existing low-price equipment by merely changing a resistance calculation scheme (e.g., by calculating an equivalent circuit) with a limitation to a frequency suitable for internal resistance measurement (e.g., about 100 Hz to about 10 kHz).

The battery-internal-resistance-measuring apparatus 100 according to embodiments of the present disclosure may include the processor 120 and the memory 110.

The processor 120 may control an overall operation of the battery-internal-resistance-measuring apparatus 100. The processor 120 may perform basic arithmetic, logic, and input/output operations, and may execute a program code stored in the memory 110. For example, the processor 120 may be implemented in a form selectively including a processor, an application-specific integrated circuit (ASIC), another chipset, a logic circuit, a register, a communication modem, and/or a data processing device, etc., known in this field. The processor 120 may store data in the memory 110, or may load data stored in the memory 110.

The memory 110 may include a permanent mass storage device, such as random access memory (RAM), read only memory (ROM), and disk drive, as a recording medium readable by the processor 120. The memory 110 may store an operating system and at least one program or application code. The memory 110 may store data regarding an equivalent circuit model including resistance elements and inductance elements respectively corresponding to an internal resistance component of the battery 10 and a resistance component of the battery-internal-resistance-measuring apparatus 100, and an inductance component of the battery-internal-resistance-measuring apparatus 100. For example, as shown in FIG. 2, the battery-internal-resistance-measuring apparatus may include the battery-internal-resistance-measuring apparatus 100, which may also include the elements mentioned above, such as the memory 110, the processor 120 and/or a communication module 130, and the jig 50.

The battery-internal-resistance-measuring apparatus 100 according to embodiments of the present disclosure may further include a communication module 130. For example, the battery-internal-resistance-measuring apparatus 100 may exchange data with an external device by using the communication module 130.

A communication scheme of the communication module 130 is not limited, and may include short-range wireless communication between devices, as well as communications using a communication network (e.g., a mobile communication network, wired Internet, wireless Internet, a broadcast network). For example, the network may include one or more networks among a personal area network (PAN), a local area network (LAN), a campus area network (CAN), a metropolitan area network (MAN), a wide area network (WAN), a broadband network (BBN), Internet, etc. Moreover, the network may include, but is not limited to, one or more of network topology including a bus network, a start network, a ring network, a mesh network, a star-bus network, a tree or hierarchical network, etc.

The battery-internal-resistance-measuring apparatus 100 according to the present disclosure may further include an input/output interface. The input/output interface may be a means for an interface with an input/output device. For example, the input device may include a keyboard, a mouse, etc., and the output device may include a display for displaying a communication session of an application, etc. In another example, the input/output interface may be a means for an interface with a device in which a function for input and a function for output are integrated into one, such as a touch screen.

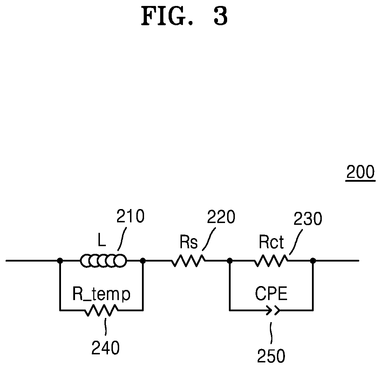

FIG. 3 is a view for describing an equivalent circuit model according to embodiments of the present disclosure.

Referring to FIG. 3, there is shown an equivalent circuit model 200 used by the battery-internal-resistance-measuring apparatus 100 for deriving an internal resistance value according to embodiments of the present disclosure. A battery-internal-resistance-measuring method according to the present disclosure may use the battery-internal-resistance-measuring apparatus 100 of FIG. 1.

If there is used a frequency that is lower than 100 Hz of a frequency of about 100 Hz to about 10 kHz, as proposed by the battery-internal-resistance-measuring apparatus 100 according to embodiments of the present disclosure (e.g., measured and analyzed), a measurement time may be lengthened, which may be inappropriate for mass production equipment. Moreover, analysis is insufficient with an equivalent circuit model according to the present disclosure, such that an element for expressing a low frequency may be suitably added. Furthermore, measuring a resistance around 1 kHz in the mass production equipment may identify a product having a relatively high possibility of an internal short-circuit defect.

For example, as shown in FIG. 3, the equivalent circuit model according to embodiments of the present disclosure may include L (e.g., an inductance element 210), R_temp (e.g., a resistance element 240), Rs (e.g., a resistance element 220), and CPE (e.g., a capacitance element 250).

Herein, L may indicate inductance components of a cable and an engagement jig connected to the battery-internal-resistance-measuring apparatus 100. R_temp may indicate resistance components of a cable and an engagement jig connected to the battery-internal-resistance-measuring apparatus 100. Rs may indicate an internal resistance component of the battery 10, and resistance components (e.g., an electrolyte, a separator, a terminal, a safety device, etc.) not involving an electrochemical reaction (oxidation and reduction) among internal components and materials of the battery 10. Rct may indicate an oxidation or reduction reaction speed and may be represented by a resistance value 230. A greater value of Rct may mean a higher resistance and a lower reaction speed. CPE may indicate an electric double layer capacitance, and may indicate an electrified layer formed on an electrode surface where oxidation or reduction occurs.

The processor 120 may obtain an initial internal resistance value of the battery 10 from the battery-internal-resistance-measuring apparatus 100 that is electrically connected to the battery 10. The processor 120 may fit an equivalent circuit model based on the initial internal resistance value. The processor 120 may also derive the internal resistance value of the battery 10 based on a fitting result of the equivalent circuit model.

For example, the processor 120 may fit an equivalent circuit model including a resistance element corresponding to a resistance component (e.g., see R_temp in FIG. 3) of the battery-internal-resistance-measuring apparatus 100 electrically connected in parallel to an inductance element (e.g., see L in FIG. 3) corresponding to the inductance component of the battery-internal-resistance-measuring apparatus 100.

The processor 120 may fit an equivalent circuit model including a resistance element (e.g., see Rs in FIG. 3) corresponding to an internal resistance component of the battery 10 resistance component electrically connected in series with the inductance element corresponding to the inductance component of the battery-internal-resistance-measuring apparatus 100.

The processor 120 may also calculate the internal resistance value of the battery 10 for a frequency range (e.g., a preset frequency range). For example, the processor 120 may calculate the internal resistance value of the battery 10 for a range of about 100 Hz to about 10 kHz.

The processor 120 according to embodiments of the present disclosure may fit the equivalent circuit model by using Equation 1. For example, Equation 1 may show the equivalent circuit model shown in FIG. 3.

Equation 1

$$\left[Z_L(\omega)||Z_{R_{temp}}(\omega)\right] + Z_{R_s}(\omega) + \left[Z_{R_{ct}}(\omega)||Z_{CPE}(\omega)\right] = \frac{j\omega LR_{temp}}{j\omega L + R_{temp}} + Rs + \frac{Rct(A - jB)}{Rct + (A - jB)}$$

$$= \frac{j\omega LR_{temp}(j\omega L - R_{temp})}{(j\omega L + R_{temp})(j\omega L - R_{temp})} + Rs + \frac{Rct(A - jB)(Rct + A + jB)}{(Rct + A - jB)(Rct + A + jB)}$$

$$= \frac{j\omega LR_{temp}(j\omega L - R_{temp})}{(j\omega L + R_{temp})(j\omega L - R_{temp})} + Rs + \frac{Rct(A - jB)(Rct + A + jB)}{(Rct + A)^2 + B^2}$$

$$= \left[Rs + \frac{(\omega L)^2 R_{temp}}{(\omega L^2 + R_{temp}^2)} + \frac{Rct(RctA + A^2 + B^2)}{(Rct + A)^2 + B^2}\right]$$

$$- j\left[\frac{\omega LR_{temp}^2}{(\omega L^2 + R_{temp}^2)} + \frac{Rct^2 B}{(Rct + A)^2 + B^2}\right]$$

Herein, $Z_L(\omega) = j\omega L$, $Z_{R\_temp}(\omega) = R_{temp}$, $Z_{R\_s}(\omega) = R_s$, $Z_{Rct}(\omega) = R_{ct}$, $Z_{CPE}(\omega) = Y_{CPE}(\omega)^{-1} = [CPE_T(j\omega)^{CPE_P}]^{-1} = \left[\frac{1}{CPE_T(\omega)^{CPE_P}}\cos\left(\frac{CPE_T\times\pi}{2}\right)\right] - j\left[\frac{1}{CPE_T(\omega)^{CPE_P}}\sin\left(\frac{CPE_T\times\pi}{2}\right)\right] = A - Jb$, $A = \left[\frac{1}{CPE_T(\omega)^{CPE_P}}\cos\left(\frac{CPE_T\times\pi}{2}\right)\right]$, $B = \left[\frac{1}{CPE_T(\omega)^{CPE_P}}\sin\left(\frac{CPE_T\times\pi}{2}\right)\right]$.

The equivalent circuit model according to the present disclosure may configure a resistor R_temp connected in parallel to an inductance L. By configuring the resistor to be parallel to the inductance (e.g., electrically connected in parallel to the inductance), fitting for the inductance may be accurately performed.

To calculate values of elements of an equivalent circuit, the processor 120 may obtain an initial internal resistance value of the battery 10 from the battery-internal-resistance-measuring apparatus 100 electrically connected to the battery 10. In one or more embodiments, a user may arbitrarily input the initial internal resistance value, for example via an input device as mentioned above and connected to the input/output interface of the battery-internal-resistance-measuring apparatus or otherwise connected to the battery-internal-resistance-measuring apparatus.

The processor 120 may calculate a value of each element by using an equivalent circuit model equation after measuring the initial internal resistance value. Next, the processor 120 may calculate an Rs value that is an internal resistance value of the battery 10.

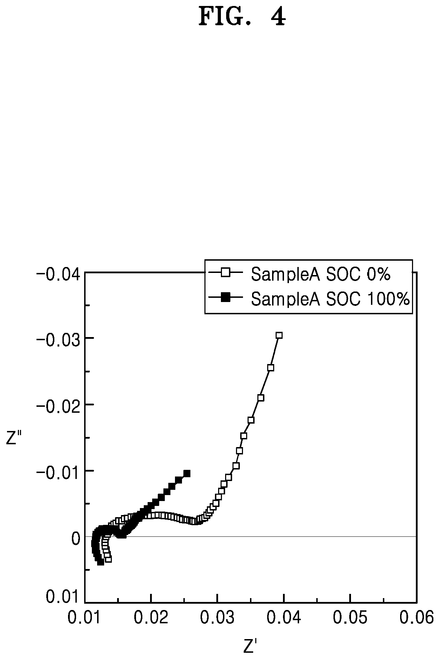

FIGS. 4 to 6 show graphs (Nyquist plots) of a result of measuring an internal resistance of a battery, according to embodiments of the present disclosure.

Referring to FIG. 4, a result of measuring an internal resistance for an SoC of 100 % and an SoC of 0 % of a battery (Sample A), according to embodiments of the present disclosure, is shown. Herein, a dot may indicate an actually measured initial internal resistance value, and a solid line may indicate an internal resistance value calculated by fitting an equivalent circuit model.

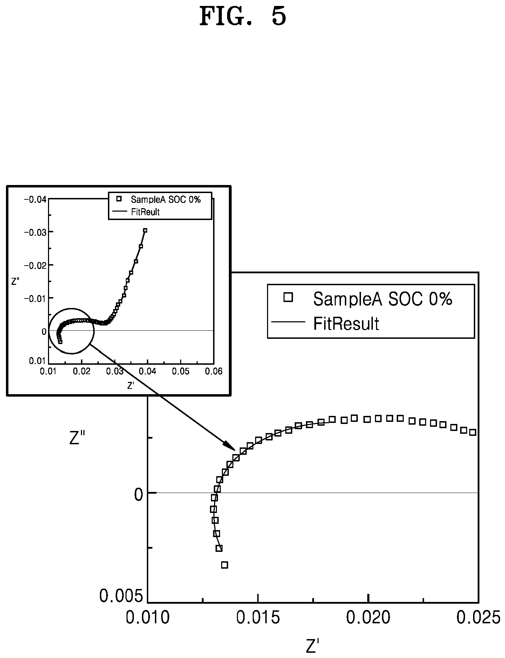

Referring to FIG. 5 together, a fitting result (a solid line) using measurement data of a frequency domain of about 100 Hz to about 10 kHz limited to the equivalent circuit model, proposed by the present disclosure, and EIS measurement, for an SoC of 0 % of the battery (Sample A), is shown.

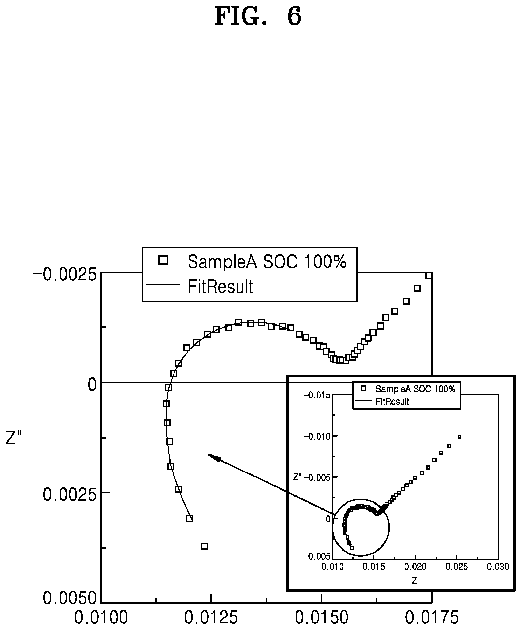

Referring to FIG. 6 together, a fitting result (a solid line) using measurement data of a frequency domain of about 100 Hz to about 10 kHz limited to the equivalent circuit model, proposed by the present disclosure, and EIS measurement, for an SoC of 100 % of the battery (Sample A), is shown.

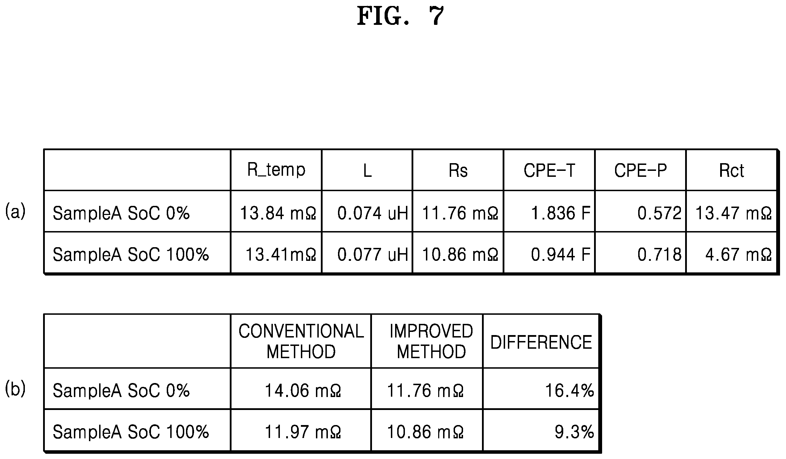

FIG. 7 shows data of a result of measuring an internal resistance of a battery, according to embodiments of the present disclosure.

Referring to FIG. 7, (a) of FIG. 7 shows a result of calculating a value of each element by using an equivalent-circuit-model-fitting method according to the present disclosure, and shows a result of calculating an internal resistance value of the battery based on the calculated value. (b) of FIG. 7 shows a result of comparing a conventional internal resistance measurement result with an internal resistance measurement result according to the present disclosure. It may be seen that a result according to the present disclosure is more accurate than a result of a conventional method (e.g., measurement logic of commercial equipment) by about 9.3 % to about 16.4 %.

Use of a conventional battery internal resistance value is managed suitably for a production line or a production process, and is used for determining whether the battery is good or bad, and may be data that is not secondarily used. In spite of different production line and base of the battery and a difference in a form factor, by accurately measuring an internal resistance suitably for the production line and base, the measured internal resistance may be used for quality management, a database, and battery development. In a system using a plurality of batteries, like those for electric vehicles and ESS systems, the corresponding method may be included in the BMS, thereby allowing accurate monitoring of the battery.

While the present disclosure is described by limited embodiments and drawings, the present disclosure is not limited thereby, and various modifications and changes may be made by those of ordinary skill in the art within the present disclosure and the range to the claims set forth below.

Various embodiments of the present disclosure may be implemented in the form of a computer program executable on a computer through various components, and the computer program may be recorded on a computer-readable medium. The medium may continuously store an executable program or temporarily store the same for execution or downloading. The medium may include various recording means or storage means in a form of single hardware or a combination of several hardware, and may be distributed over a network without being limited to a medium directly connected to a certain computer system. Examples of the medium may include a magnetic medium, such as a hard disk, a floppy disk, and a magnetic tape, an optical recording medium, such as a CD-ROM and a DVD, a magneto-optical medium, such as a floptical disk, ROM, RAM, flash memory, etc., to store a program instruction. Other examples of the medium may include a recording medium or a storage medium managed by an app store that distributes applications, a site that supplies or distributes various software, a server, etc.

According to the present disclosure, by accurately measuring an internal resistance value of a battery, the internal resistance value may be used for battery quality management, a database, and battery development.

Aspects that may be obtained through the present disclosure are not limited to the above-described aspects, and other aspects not mentioned may be clearly understood by those of ordinary skill in the art from the description of the present disclosure described below.

It should be understood that embodiments described herein should be considered in a descriptive sense only and not for purposes of limitation. Descriptions of aspects within the embodiments should typically be considered as available for other similar aspects in other embodiments. While one or more embodiments have been described with reference to the figures, it will be understood by those of ordinary skill in the art that various changes in form and details may be made therein without departing from scope of the present disclosure as defined by the following claims.

**Claims**

1. A method of measuring an internal resistance of a battery (10) by using a battery-internal-resistance-measuring apparatus (100), wherein the method is **characterised by** comprising:

    obtaining an initial internal resistance of the battery (10) electrically connected to the battery-internal-resistance-measuring apparatus (100);
    fitting an equivalent circuit model (200) comprising resistance elements (220, 240), which correspond to an internal resistance component of the battery (10) and a resistance component of the battery-internal-resistance-measuring apparatus (100), and an inductance element (210), which correspond to an inductance component of the battery-internal-resistance-measuring apparatus (100), based on the initial internal resistance; and
    deriving an internal resistance value of the battery (10) based on a fitting result of the equivalent circuit model.

2. The method as claimed in claim 1, wherein the equivalent circuit model (200) comprises one of the resistance elements (240) corresponding to the resistance component connected in parallel to the inductance element (210) corresponding to the inductance component.

3. The method as claimed in claim 1 or claim 2, wherein the equivalent circuit model (200) comprises another one of the resistance elements (220) corresponding to the internal resistance component connected in series to the inductance element (210).

4. The method as claimed in one of claims 1 to 3, wherein the deriving of the internal resistance value comprises calculating the internal resistance value for a frequency range.

5. The method as claimed in claim 4, wherein the frequency range is about 100 Hz to about 10 kHz.

6. The method as claimed in one of claims 1 to 5, wherein a value of each element of the equivalent circuit model (200) is calculated by using an equivalent circuit model equation after measuring the initial internal resistance value.

7. The method as claimed in one of claims 1 to 6, wherein, based on the calculated values of the elements of the equivalent circuit model (200), an Rs value that is an internal resistance value of the battery is calculated.

8. The method as claimed in one of claims 1 to 7, wherein the method is executed by a computer program stored on a recording medium by using a computing device.

9. A battery-internal-resistance-measuring apparatus (100) for measuring an internal resistance of a battery (10) electrically connected thereto, **characterised in that** the battery-internal-resistance-measuring apparatus (100) comprises:

   a resistance component;
   an inductance component;
   a memory (110) configured to store an equivalent circuit model (200) comprising resistance elements (220, 240) corresponding to an internal resistance component of the battery (100) and the resistance component, and an inductance element (210) corresponding to the inductance component; and
   a processor (120) configured to obtain an initial internal resistance value of the battery (10), configured to fit the equivalent circuit model (200) based on the initial internal resistance value to generate a fitting result, and configured to derive an internal resistance value of the battery (10) based on the fitting result.

10. The battery-internal-resistance-measuring apparatus (100) as claimed in claim 9, wherein the equivalent circuit model (200) comprises one of the resistance elements (240) corresponding to the resistance component connected in parallel to the inductance element (210).

11. The battery-internal-resistance-measuring apparatus (100) as claimed in claim 9 or claim 10, wherein the equivalent circuit model (200) comprises another one of the resistance elements (220) corresponding to the internal resistance component connected in series with the inductance element (210).

12. The battery-internal-resistance-measuring apparatus (100) as claimed in claim one of claims 9 to 11, wherein the processor (120) is further configured to calculate the internal resistance value for a frequency range.

13. The battery-internal-resistance-measuring apparatus (100) as claimed in claim 12, wherein the frequency range is about 100 Hz to about 10 kHz.

14. The battery-internal-resistance-measuring apparatus (100) as claimed in one of claims 9 to 13, wherein the processor (120) is configured to calculate a value of each element of the equivalent circuit model (200) by using an equivalent circuit model equation after measuring the initial internal resistance value.

15. The battery-internal-resistance-measuring apparatus (100) as claimed in one of claims 9 to 14, wherein the processor (120) is configured to calculate, based on the calculated values of the elements of the equivalent circuit model (200), an Rs value that is an internal resistance value of the battery (10).


**Patentansprüche**

1. Verfahren zur Messung eines Innenwiderstands einer Batterie (10) unter Verwendung einer Batterie-Innenwiderstandsmessvorrichtung (100), wobei das Verfahren **dadurch gekennzeichnet ist, dass** es Folgendes umfasst:

   Erhalten eines anfänglichen Innenwiderstands der Batterie (10), die elektrisch mit der Batterie-Innenwiderstandsmessvorrichtung (100) verbunden ist;
   Anpassen eines Ersatzschaltungsmodells (200), das Widerstandselemente (220, 240), die einer Innenwiderstandskomponente der Batterie (10) und einer Widerstandskomponente der Batterie-Innenwiderstandsmessvorrichtung (100) entsprechen, und ein Induktivitätselement (210) umfasst, das einer Induktivitätskomponente der Batterie-Innenwiderstandsmessvorrichtung (100) entspricht, auf der Grundlage des anfänglichen Innenwiderstands; und
   Ableiten eines Innenwiderstandswerts der Batterie (10) auf der Grundlage eines Anpassungsergebnisses des Ersatzschaltungsmodells.

2. Verfahren nach Anspruch 1, wobei das Ersatzschaltungsmodell (200) eines der Widerstandselemente (240) umfasst, das der Widerstandskomponente entspricht, die parallel zu dem Induktivitätselement (210) geschaltet ist, das der Induktivitätskomponente entspricht.

3. Verfahren nach Anspruch 1 oder Anspruch 2, wobei das Ersatzschaltbildmodell (200) ein weiteres der Widerstandselemente (220) umfasst, das der Innenwiderstandskomponente entspricht, die mit dem Induktivitätselement (210) in Reihe geschaltet ist.

4. Verfahren nach einem der Ansprüche 1 bis 3, wobei das Ableiten des Innenwiderstandswerts das Berechnen des Innenwiderstandswerts für einen Frequenzbereich umfasst.

5. Verfahren nach Anspruch 4, wobei der Frequenzbereich etwa 100 Hz bis etwa 10 kHz beträgt.

6. Verfahren nach einem der Ansprüche 1 bis 5, wobei ein Wert jedes Elements des Ersatzschaltungsmodells (200) unter Verwendung einer Ersatzschaltungsmodellgleichung nach dem Messen des anfänglichen Innenwiderstandswerts berechnet wird.

7. Verfahren nach einem der Ansprüche 1 bis 6, wobei auf der Grundlage der berechneten Werte der Elemente des Ersatzschaltungsmodells (200) ein Rs-Wert berechnet wird, der ein Innenwiderstandswert der Batterie ist.

8. Verfahren nach einem der Ansprüche 1 bis 7, wobei das Verfahren durch ein auf einem Aufzeichnungsmedium gespeichertes Computerprogramm unter Verwendung einer Rechenvorrichtung ausgeführt wird.

9. Batterie-Innenwiderstandsmessvorrichtung (100) zur Messung eines Innenwiderstands einer Batterie (10), die elektrisch mit dieser verbunden ist, **dadurch gekennzeichnet, dass** die Batterie-Innenwiderstandsmessvorrichtung (100) Folgendes umfasst:

eine Widerstandskomponente;
eine Induktivitätskomponente;
einen Speicher (110), der dazu konfiguriert ist, ein Ersatzschaltungsmodell (200) zu speichern, das Widerstandselemente (220, 240), die einer Innenwiderstandskomponente der Batterie (100) und der Widerstandskomponente entsprechen, und ein Induktivitätselement (210) umfasst, das der Induktivitätskomponente entspricht; und
einen Prozessor (120), der dazu konfiguriert ist, einen anfänglichen Innenwiderstandswert der Batterie (10) zu erhalten, das Ersatzschaltungsmodell (200) auf der Grundlage des anfänglichen Innenwiderstandswerts anzupassen, um ein Anpassungsergebnis zu erzeugen, und auf der Grundlage des Anpassungsergebnisses einen Innenwiderstandswert der Batterie (10) abzuleiten.

10. Batterie-Innenwiderstandsmessvorrichtung (100) nach Anspruch 9, wobei das Ersatzschaltbildmodell (200) eines der Widerstandselemente (240) umfasst, das der Widerstandskomponente entspricht, die parallel zu dem Induktivitätselement (210) geschaltet ist.

11. Batterie-Innenwiderstandsmessvorrichtung (100) nach Anspruch 9 oder Anspruch 10, wobei das Ersatzschaltbildmodell (200) ein weiteres der Widerstandselemente (220) umfasst, das der Innenwiderstandskomponente entspricht, die mit dem Induktivitätselement (210) in Reihe geschaltet ist.

12. Batterie-Innenwiderstandsmessvorrichtung (100) nach einem der Ansprüche 9 bis 11, wobei der Prozessor (120) ferner dazu konfiguriert ist, den Innenwiderstandswert für einen Frequenzbereich zu berechnen.

13. Batterie-Innenwiderstandsmessvorrichtung (100) nach Anspruch 12, wobei der Frequenzbereich etwa 100 Hz bis etwa 10 kHz beträgt.

14. Batterie-Innenwiderstandsmessvorrichtung (100) nach einem der Ansprüche 9 bis 13, wobei der Prozessor (120) dazu konfiguriert ist, nach dem Messen des anfänglichen Innenwiderstandswerts einen Wert jedes Elements des Ersatzschaltungsmodells (200) unter Verwendung einer Ersatzschaltungsmodellgleichung zu berechnen.

15. Batterie-Innenwiderstandsmessvorrichtung (100) nach einem der Ansprüche 9 bis 14, wobei der Prozessor (120) dazu konfiguriert ist, auf der Grundlage der berechneten Werte der Elemente des Ersatzschaltungsmodells (200) einen Rs-Wert zu berechnen, der ein Innenwiderstandswert der Batterie (10) ist.

**Revendications**

1. Procédé de mesure d'une résistance interne d'une batterie (10) à l'aide d'un appareil de mesure de résistance interne de batterie (100), dans lequel le procédé est **caractérisé en ce qu'**il comporte :

   l'obtention d'une résistance interne initiale de la batterie (10) connectée électriquement à l'appareil de mesure de résistance interne de batterie (100) ;
   l'ajustement d'un modèle de circuit équivalent (200) comportant des éléments de résistance (220, 240), qui correspondent à un composant de résistance interne de la batterie (10) et à un composant de résistance de l'appareil de mesure de résistance interne de batterie (100), et un élément d'inductance (210), qui correspond à un composant d'inductance de l'appareil de mesure de résistance interne de batterie (100), sur la base de la résistance interne initiale ; et
   la dérivation d'une valeur de résistance interne de la batterie (10) sur la base d'un résultat d'ajustement du modèle de circuit équivalent.

2. Procédé selon la revendication 1, dans lequel le modèle de circuit équivalent (200) comporte un parmi les éléments de résistance (240) correspondant au composant de résistance connecté en parallèle à l'élément d'inductance (210) correspondant au composant d'inductance.

3. Procédé selon la revendication 1 ou la revendication 2, dans lequel le modèle de circuit équivalent (200) comporte un autre parmi les éléments de résistance (220) correspondant au composant de résistance interne connecté en série à l'élément d'inductance (210).

4. Procédé selon l'une quelconque des revendications 1 à 3, dans lequel la dérivation de la valeur de résistance interne comporte le calcul de la valeur de résistance interne pour une plage de fréquences.

5. Procédé selon la revendication 4, dans lequel la plage de fréquences est d'environ 100 Hz à environ 10 kHz.

6. Procédé selon l'une des revendications 1 à 5, dans lequel une valeur de chaque élément du modèle de circuit équivalent (200) est calculée en utilisant une équation de modèle de circuit équivalent après mesure de la valeur de résistance interne initiale.

7. Procédé selon l'une des revendications 1 à 6, dans lequel, sur la base des valeurs calculées des éléments du modèle de circuit équivalent (200), une valeur Rs qui est une valeur de résistance interne de la batterie est calculée.

8. Procédé selon l'une des revendications 1 à 7, dans lequel le procédé est exécuté par un programme informatique stocké sur un support d'enregistrement en utilisant un dispositif informatique.

9. Appareil de mesure de résistance interne de batterie (100) pour mesurer une résistance interne d'une batterie (10) connectée électriquement à celui-ci, **caractérisé en ce que** l'appareil de mesure de résistance interne de batterie (100) comporte :

   un composant de résistance ;
   un composant d'inductance ;
   une mémoire (110) configurée pour stocker un modèle de circuit équivalent (200) comportant des éléments de résistance (220, 240) correspondant à un composant de résistance interne de la batterie (100) et au composant de résistance, et un élément d'inductance (210) correspondant au composant d'inductance ; et
   un processeur (120) configuré pour obtenir une valeur de résistance interne initiale de la batterie (10), configuré pour ajuster le modèle de circuit équivalent (200) sur la base de la valeur de résistance interne initiale pour générer un résultat d'ajustement, et configuré pour dériver une valeur de résistance interne de la batterie (10) sur la base du résultat d'ajustement.

10. Appareil de mesure de résistance interne de batterie (100) selon la revendication 9, dans lequel le modèle de circuit équivalent (200) comporte un parmi les éléments de résistance (240) correspondant au composant de résistance connecté en parallèle à l'élément d'inductance (210).

11. Appareil de mesure de résistance interne de batterie (100) selon la revendication 9 ou la revendication 10, dans lequel le modèle de circuit équivalent (200) comporte un autre parmi les éléments de résistance (220) correspondant au composant de résistance interne connecté en série avec l'élément d'inductance (210).

12. Appareil de mesure de résistance interne de batterie (100) selon l'une des revendications 9 à 11, dans lequel le processeur (120) est en outre configuré pour calculer la valeur de résistance interne pour une plage de fréquences.

13. Appareil de mesure de résistance interne de batterie (100) selon la revendication 12, dans lequel la plage de fréquence est d'environ 100 Hz à environ 10 kHz.

14. Appareil de mesure de résistance interne de batterie (100) selon l'une des revendications 9 à 13, dans lequel le processeur (120) est configuré pour calculer une valeur de chaque élément du modèle de circuit équivalent (200) en utilisant une équation de modèle de circuit équivalent après mesure de la valeur de résistance interne initiale.

15. Appareil de mesure de résistance interne de batterie (100) selon l'une des revendications 9 à 14, dans lequel le processeur (120) est configuré pour calculer, sur la base des valeurs calculées des éléments du modèle de circuit équivalent (200), une valeur Rs qui est une valeur de résistance interne de la batterie (10).

# FIG. 1

BATTERY INTERNAL
RESISTANCE MEASURING
APPARATUS ⟋100

MEMORY ⟋110

PROCESSOR ⟋120

COMMUNICATION
MODULE ⟋130

BATTERY ⟋10

JIG ⟋50

NETWORK

FIG. 2

# FIG. 3

# FIG. 4

# FIG. 5

# FIG. 6

# FIG. 7

(a)

|  | R_temp | L | Rs | CPE-T | CPE-P | Rct |
|---|---|---|---|---|---|---|
| SampleA SoC 0% | 13.84 mΩ | 0.074 uH | 11.76 mΩ | 1.836 F | 0.572 | 13.47 mΩ |
| SampleA SoC 100% | 13.41mΩ | 0.077 uH | 10.86 mΩ | 0.944 F | 0.718 | 4.67 mΩ |

(b)

|  | CONVENTIONAL METHOD | IMPROVED METHOD | DIFFERENCE |
|---|---|---|---|
| SampleA SoC 0% | 14.06 mΩ | 11.76 mΩ | 16.4% |
| SampleA SoC 100% | 11.97 mΩ | 10.86 mΩ | 9.3% |

EP 4 582 821 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022113377 A